# EUROPÄISCHE PATENTANMELDUNG

(11) **EP 1 134 801 A2**
(43) Veröffentlichungstag der Anmeldung: **19.09.2001**
(21) Anmeldenummer: 01106707.1
(22) Anmeldetag: 16.03.2001
(51) Int. Cl.: H01L 21/66

(54) **Verfahren zur Herstellung und Überprüfung von Strukturen elektronischer Schaltungen in einem Halbleitersubstrat**

(30) Priorität: 17.03.2000 DE 10014914
(71) Anmelder: Infineon Technologies AG, 81669 München (DE)
(72) Erfinder: Karl, Jürgen, 81739 München (DE); Zibert, Martin, 83620 Feldkirchen-Westerham (DE); Rosskopf, Valentin, Dr., 86554 Poettmes-Schorn (DE)
(74) Vertreter: Reinhard - Skuhra - Weise & Partner

(57) **Zusammenfassung**

Die Erfindung betrifft ein Verfahren zur Herstellung und Überprüfung wenigstens zweier Strukturen (5, 6) einer elektronischen Schaltung in einem Halbleitersubstrat. Mit zwei unterschiedlichen Masken werden in zwei Verfahrensschritten in Nutzflächen (3) des Halbleitersubstrats identische Anordnungen von ersten und zweiten Strukturen -(5, 6) erzeugt. Im Ritzrahmen (4), der die Nutzfläche (3) umrandet, werden mit der ersten Maske nur erste Strukturen (5) und mit der zweiten Maske nur zweite Strukturen (6) erzeugt.

## Beschreibung

Die Erfindung betrifft ein Verfahren zur Herstellung und Überprüfung wenigstens zweier Strukturen einer elektronischen Schaltung in einem Halbleitersubstrat.

Derartige elektronische Schaltungen sind typischerweise als integrierte Schaltungen auf einem Wafer, vorzugsweise einem Silizium-Wafer ausgebildet. Die integrierten Schaltungen können beispielsweise von DRAM-Speicherzellen gebildet sein. Ein Wafer enthält eine flächige Anordnung einer Vielzahl von derartigen DRAM-Speicherzellen, welche in Form von Chips ausgebildet sind. Die Chipflächen der einzelnen Chips bilden die Nutzflächen des Wafers. Die einzelnen Nutzflächen sind von Ritzrahmen, sogenannten Kerfs umrandet. In diesen Ritzrahmen befinden sich elektronische Schaltungen, mittels derer die Funktionsfähigkeit und Zuverlässigkeit der elektronischen Schaltungen auf den einzelnen Chipflächen überprüft wird.

Chips mit Standard-DRAM-Speicherzellen weisen üblicherweise eine Anordnung von Transistoren mit einer bestimmten Gate-Oxid-Dicke auf. Zur Überprüfung dieser Transistoren sind in den Ritzrahmen baugleiche Transistoren angeordnet. Diese Transistoren im Ritzrahmen bilden Monitoring- und Zuverlässigkeitsstrukturen, die zur Durchführung vorgegebener Mess- und Prüfschritte verwendet werden. Anhand dieser Mess- und Prüfschritte lassen sich Aussagen über die Funktionsfähigkeit und Zuverlässigkeit der Transistoren auf den Chipflächen der einzelnen Chips ableiten.

Um möglichst zuverlässige statistische Aussagen bei den Mess- und Prüfschritten zu erhalten ist es wünschenswert, eine möglichst große Anzahl von Transistoren in den Ritzrahmen zu platzieren. Jedoch ist die maximale Anzahl der Transistoren in den Ritzrahmen dadurch begrenzt, dass die Chip-Ausbeute pro Wafer möglichst hoch sein soll. Dies begrenzt die zur Verfügung stehende Fläche der Ritzrahmen und damit die Anzahl der dort platzierten Transistoren.

Bei neuartigen DRAM-Speicherzellen, die zum Beispiel für RAMBUS Chips benötigt werden, werden aufgrund der zu erzielenden Leistungsfähigkeit und Zuverlässigkeit derartiger Elemente Transistoren mit mehreren, vorzugsweise zwei unterschiedlichen Gate-Oxid-Dicken benötigt.

Dementsprechend müssen zur Überprüfung dieser Strukturen in den Ritzrahmen Transistoren sowohl mit geringen als auch mit großen Gate-Oxid-Dicken vorgesehen werden, damit die Funktionsfähigkeit und Zuverlässigkeit beider Strukturen abprüfbar ist.

Damit im Vergleich zu Standard-DRAM-Speicherzellen für jede Sorte von Transistoren dieselbe Anzahl in den Ritzrahmen zur Verfügung steht, müssten die Flächen der Ritzrahmen vergrößert werden, was zu einer unerwünschten Reduzierung der Chipflächen führen würde.

Der Erfindung liegt die Aufgabe zugrunde ein Verfahren zu schaffen, welches eine möglichst zuverlässige Überprüfung verschiedener Strukturen einer elektronischen Schaltung in einem Halbleitersubstrat gewährleistet, ohne dass dessen Nutzfläche eingeschränkt wird.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Das erfindungsgemäße Verfahren zur Herstellung und Überprüfung wenigstens zweier Strukturen einer elektronischen Schaltung in einem Halbleitersubstrat umfasst folgende Verfahrensschritte:

Mit einer ersten Maske, bestehend aus einer sich über erste Bereiche des Halbleitersubstrats erstreckenden Anordnung von Nutzflächen und diese umrandenden Ritzrahmen, werden nach einem vorgegebenen Muster erste und zweite Strukturen in den Nutzflächen erzeugt und in den Ritzrahmen erste Strukturen erzeugt.

Mit einer zweiten Maske bestehend aus einer sich über zweite Bereiche des Halbleitersubstrats erstreckenden Anordnung von Nutzflächen und diese umrandenden Ritzrahmen werden nach dem vorgegebenen Muster erste und zweite Strukturen in den Nutzflächen erzeugt und in den Ritzrahmen zweite Strukturen erzeugt.

Die ersten Strukturen in den Ritzrahmen der ersten Bereiche und die Strukturen in den Ritzrahmen der zweiten Bereiche werden jeweils zur Überprüfung der ersten und zweiten Strukturen in den Nutzflächen verwendet.

Der Grundgedanke der Erfindung liegt somit darin, dass mit den beiden Masken in den jeweiligen ersten oder zweiten Bereichen in den Nutzflächen identisch ausgebildete erste und zweite Strukturen erzeugt werden, jedoch in den Ritzrahmen entweder nur erste oder nur zweite Strukturen erzeugt werden.

Die ersten und zweiten Bereiche sind dabei alternierend und vorzugsweise schachbrettartig über die gesamte Oberfläche des Halbleitersubstrats verteilt. In den ersten Bereichen sind dabei in den Ritzrahmen nur die ersten Strukturen angeordnet, so dass in diesen Bereichen nur eine Überprüfung von ersten Strukturen erfolgt, obwohl sich in den zugeordneten Nutzflächen sowohl erste als auch zweite Strukturen befinden. Entsprechend sind in den zweiten Bereichen nur zweite Strukturen angeordnet, so dass dort nur deren Funktionsfähigkeit überprüfbar ist, obwohl sich in den zugeordneten Nutzflächen der zweiten Bereiche sowohl erste und zweite Strukturen befinden.

Durch diese Anordnung werden die ersten und zweiten Strukturen in separaten Bereichen getrennt geprüft. Ein wesentlicher Vorteil besteht darin, dass in sämtlichen Ritzrahmen beider Bereiche jeweils nur eine Struktur von elektronischen Schaltungen vorhanden ist, so dass die Anzahl der Strukturen in einem Ritzrahmen klein gehalten werden kann. Dies bedeutet, dass die Fläche der Ritzrahmen entsprechend klein und die Nutzflächen entsprechend groß dimensioniert werden können, so dass eine entsprechend hohe Ausbeute bei der Herstellung von elektronischen Schaltungen auf dem Halbleitersubstrat erhalten wird.

Gleichzeitig ist durch die komplementäre Anordnung von ersten und zweiten Strukturen in den Ritzrahmen der ersten und zweiten Bereiche gewährleistet, dass die Zuverlässigkeit und Funktionsfähigkeit beider Strukturen mit einer ausreichend hohen Prozesssicherheit überprüft werden kann. Besonders vorteilhaft hierbei ist die schachbrettartige Anordnung der ersten und zweiten Bereiche. Auf diese Weise sind die ersten und zweiten Strukturen in dem jeweiligen Ritzrahmen gleichmäßig über die Oberfläche des Halbleitersubstrats verteilt, so dass bei der Überprüfung der ersten und zweiten Strukturen die Oberfläche des Halbleitersubstrats jeweils gleichmäßig abgedeckt wird.

Besonders vorteilhaft werden die beiden Masken zur Ausbildung der ersten und zweiten Strukturen nur während einer Technologie-Anlaufphase verwendet. Während einer Technologie-Anlaufphase für mit den Halbleitersubstraten hergestellten Produkten besteht für diese ein erhöhter Bedarf an Mess- und Prüfschritten um die Zuverlässigkeit der Produkte ausreichend zu prüfen.

In einer auf die Technologie-Anlaufphase folgenden Produktionsphase besteht ein vergleichsweise geringerer Bedarf an Mess- und Prüfschritten.

In diesem Fall kann anstelle der Verwendung zweier Masken zur Herstellung der ersten und zweiten Strukturen eine einzige modifizierte erste Maske verwendet werden.

Diese modifizierte erste Maske weist keine Einteilung in erste und zweite Bereiche auf. Vielmehr ist die Maske so ausgebildet, dass in sämtlichen Nutzflächen die ersten und zweiten Strukturen erzeugt werden. In den Ritzrahmen werden jeweils eine vorgegebene Anzahl von ersten und zweiten Strukturen erzeugt, so dass dann in einem Ritzrahmen beide Strukturen gleichzeitig geprüft werden.

In einer vorteilhaften Ausführungsform der Erfindung sind die ersten und zweiten Strukturen von unterschiedlichen Gate-Oxid-Dicken von Transistoren gebildet, die vorzugsweise bei DRAM-Speicherzellen eingesetzt werden.

Die Erfindung wird im nachstehenden anhand der Zeichnungen erläutert. Es zeigen:
- Figur 1:: Schematische Darstellung eines ersten Bereichs einer ersten Maske zur Herstellung von Strukturen elektronischer Schaltungen in einem Halbleitersubstrat.
- Figur 2:: Schematische Darstellung eines zweiten Bereichs einer zweiten Maske zur Herstellung von Strukturen elektronischer Schaltungen.
- Figur 3:: Schematische Darstellung der Verteilung von ersten Bereichen der ersten Maske gemäß Figur 1 und zweiten Bereichen der zweiten Maske gemäß Figur 2 über der Oberfläche des Halbleitersubstrats.
- Figur 4:: Schematische Darstellung eines Bereichs einer modifizierten ersten Maske zur Herstellung von Strukturen elektronischer Schaltungen in einem Halbleitersubstrat.

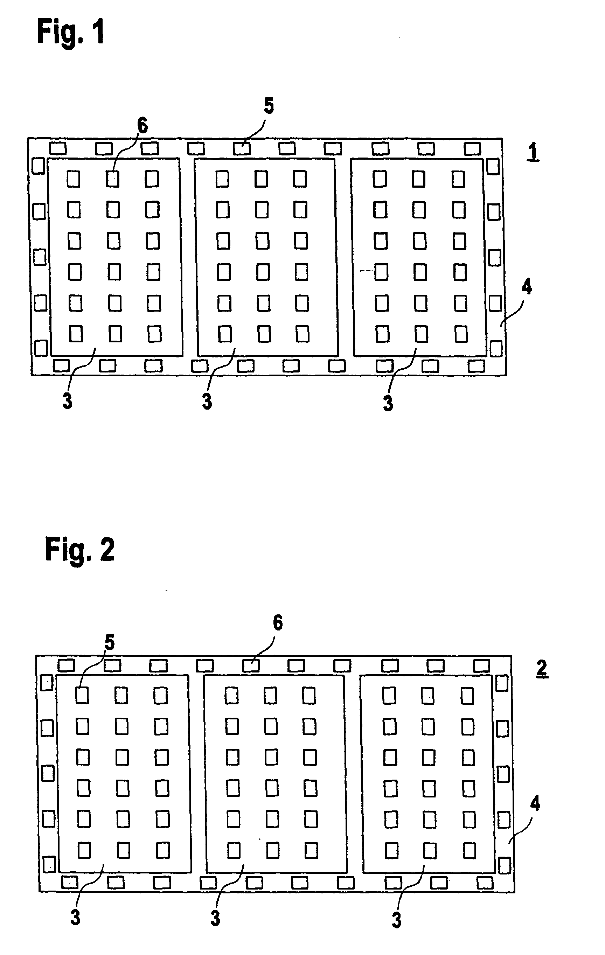

In den Figuren 1 und 2 sind schematisch zwei Bereiche 1, 2 zweier Masken dargestellt, welche zur Herstellung elektronischer Schaltungen in einem Halbleitersubstrat dienen. Eine erste Maske besteht dabei aus einer Anordnung von ersten Bereichen 1 gemäß Figur 1. Eine zweite Maske besteht aus einer Anordnung von zweiten Bereichen 2 gemäß Figur 2. Jeder Bereich 1, 2 einer Maske und damit die Oberfläche des Halbleitersubstrats ist in ein Raster von Nutzflächen 3 unterteilt, welche von Ritzrahmen 4 umrandet sind. In den Gebieten der einzelnen Nutzflächen 3 und Ritzrahmen 4 werden zwei verschiedene Strukturen 5, 6 von elektronischen Schaltungen erzeugt, deren Anordnung in den Figuren 1 und 2 schematisch dargestellt ist.

Das Halbleitersubstrat ist von einem Silizium-Wafer gebildet, welcher zur Herstellung von DRAM-Speicherzellen verwendet wird. Aus einem derartigen Silizium-Wafer wird eine große Anzahl von identisch ausgebildeten Chips gewonnen. Jeder dieser Chips enthält Anordnungen von DRAM-Speicherzellen und bildet vorzugsweise einen RAMBUS oder dergleichen.

Bei derartigen Chips werden insbesondere unterschiedliche Strukturen 5, 6 von elektronischen Schaltungen benötigt, welche als Transistoren mit unterschiedlichen Gate-Oxid-Dicken gebildet sind.

Im vorliegenden Ausführungsbeispiel sind zwei unterschiedliche Transistoren vorgesehen, wobei die eine erste Struktur bildenden Transistoren eine dünne Gate-Oxid-Schicht aufweisen und die eine zweite Struktur bildenden Transistoren eine dicke Gate-Oxid-Schicht aufweisen.

Die unterschiedlichen ersten und zweiten Strukturen 5, 6 werden mit den Masken gemäß den Figuren 1 und 2 erzeugt.

Zur Erzeugung der ersten Strukturen 5 erfolgt eine Stickstoff-Implantation in den Gate-Oxid-Bereichen der jeweiligen Transistoren. Hierzu wird der Stickstoff durch entsprechende Öffnungen in den Masken gemäß den Figuren 1 und 2 in das Halbleitersubstrat implantiert. Demgegenüber sind die Masken gemäß den Figuren 1 und 2 so ausgebildet, dass die Gate-Oxid-Bereiche der die zweiten Strukturen 6 bildenden Gate-Oxid-Bereiche während der Stickstoff-Implantation abgedeckt sind.

Im Anschluss an die Stickstoff-Implantation werden die die Gate-Oxid-Schichten bildenden Oxidschichten auf das Halbleitersubstrat aufgebracht. Bei den mit Stickstoff implantierten Gate-Oxid-Bereichen der die ersten Strukturen 5 bildenden Transistoren erfolgt durch den Stickstoff ein verlangsamtes und gehemmtes Wachstum der Oxidschichten, so dass dünne Gate-Oxid-Schichten erhalten werden. Demgegenüber werden für die nicht mit Stickstoff implantierten Gate-Oxid-Bereiche der die zweiten Strukturen 6 bildenden Transistoren dicke Gate-Oxid-Schichten erhalten.

Die in den Figuren 1 und 2 dargestellten Bereiche 1, 2 der ersten und zweiten Maske weisen jeweils einen identischen Aufbau auf. Jeder Bereich 1, 2 umfasst im vorliegenden Beispiel drei Nutzflächen 3, die den Chipflächen der zu erzeugenden Chips entsprechen. Diese Nutzflächen 3 sind von einem Ritzrahmen 4 umrandet. Die Breite des Ritzrahmens 4 ist erheblich kleiner als die Breite einer Nutzfläche 3. Im vorliegenden Ausführungsbeispiel weisen die Chipflächen einen rechteckigen Querschnitt auf, wobei der diese umrandende Ritzrahmen 4 eine ebenfalls rechteckige Kontur aufweist.

Die einzelnen Chips, die aus einem Halbleitersubstrat gewonnen werden, sind identisch ausgebildet. Demzufolge weisen sämtliche Nutzflächen 3 der Bereiche 1, 2 der Masken gemäß den Figuren 1 und 2 identische Muster auf, mit welchen jeweils identische Anordnungen von Transistoren mit dicken und dünnen Gate-Oxid-Schichten erzeugt werden.

Die in den Figuren 1 und 2 dargestellten Bereiche 1, 2 der ersten und zweiten Maske unterscheiden sich durch die Ausbildung von Teststrukturen in den Ritzrahmen 4.

Wie aus Figur 1 ersichtlich ist ist der Ritzrahmen 4 der ersten Maske so ausgebildet, dass dort nur erste Strukturen 5 bildende Transistoren mit dünnen Gate-Oxid-Schichten angeordnet sind.

Demgegenüber ist der Ritzrahmen 4 der zweiten Maske gemäß Figur 2 so ausgebildet, dass dort nur zweite Strukturen 6 bildende Transistoren mit dicken Gate-Oxid-Schichten angeordnet sind.

Mit den in den Gebieten der Ritzrahmen 4 liegenden Transistoren werden zur Überprüfung der Zuverlässigkeit und Funktionsfähigkeit vorgegebene Mess- und Prüfschritte durchgeführt.

Da in dem Gebiet des Ritzrahmens 4 des ersten Bereichs 1 der ersten Maske nur Transistoren mit dünnen Gate-Oxid-Schichten erzeugt werden, werden bei der Überprüfung nur diese ersten Strukturen 5, nicht jedoch die zweiten Strukturen 6 überprüft.

Entsprechend werden in dem Gebiet des Ritzrahmens 4 des zweiten Bereichs 2 der zweiten Maske nur Transistoren mit dicken Gate-Oxid-Schichten erzeugt, so dass dort nur die zweiten Strukturen 6 überprüft werden.

Die erste Maske besteht aus einer Anordnung von ersten Bereichen 1, welche komplementär zur Anordnung der zweiten Bereiche 2 der zweiten Maske angeordnet sind.

Somit können in einem ersten Verfahrensschritt mittels der ersten Bereiche 1 der ersten Maske in ersten Teilgebieten des Wafers erste und zweite Strukturen 5, 6 erzeugt werden. In einem zweiten Verfahrensschritt werden mittels der zweiten Bereiche 2 der zweiten Maske in den bei dem ersten Verfahrensschritt nicht bearbeiteten Teilgebieten des Wafers wiederum erste und zweite Strukturen 5, 6 erzeugt.

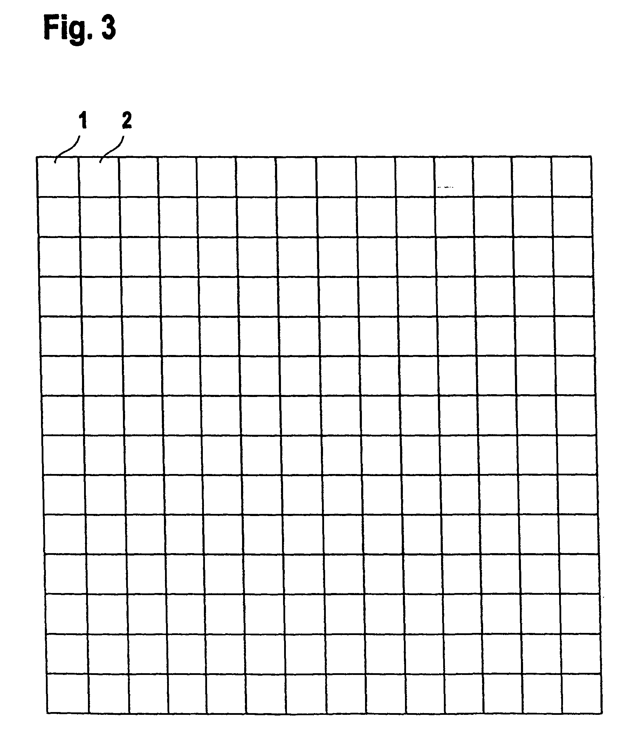

Dabei sind die ersten und zweiten Bereiche 1, 2 der ersten und zweiten Maske so angeordnet, dass diese in einer alternierenden Anordnung die Oberfläche des Wafers abdecken. Figur 3 zeigt ein Ausführungsbeispiel einer derartigen Anordnung, bei welcher die ersten Bereiche 1 der ersten Maske und die zweiten Bereiche 2 der zweiten Maske die Waferoberfläche schachbrettförmig abdecken.

Die Überprüfung der ersten und zweiten Strukturen 5, 6 erfolgt räumlich getrennt in den ersten und zweiten Bereichen 1, 2 der beiden Masken, die gleichmäßig über die Waferoberfläche verteilt sind.

Eine derartige Anordnung ist insbesondere deshalb vorteilhaft, da in den Gebieten der Ritzrahmen 4 jeweils eine genügend große Anzahl von ersten oder zweiten Strukturen 5, 6 erzeugt wird, um eine zuverlässige statistische Auswertung der einzelnen Messgrößen zu erhalten. Gleichzeitig ist die Gesamtzahl von ersten oder zweiten Strukturen 5, 6 in den Gebieten der Ritzrahmen 4 so klein, dass die Gesamtfläche des Ritzrahmens 4 klein gehalten werden kann.

Diese beiden Masken werden insbesondere während einer Technologie-Anlaufphase eingesetzt, in welcher vor der Serienfreigabe der aus den Wafern hergestellten Chips ausführliche und detaillierte Überprüfungen der ersten und zweiten Strukturen 5, 6 durchgeführt werden müssen.

In der auf die Technologie-Anlaufphase folgenden Produktionsphase werden die beiden Masken vorzugsweise nur sporadisch für einige Fertigungslose verwendet.

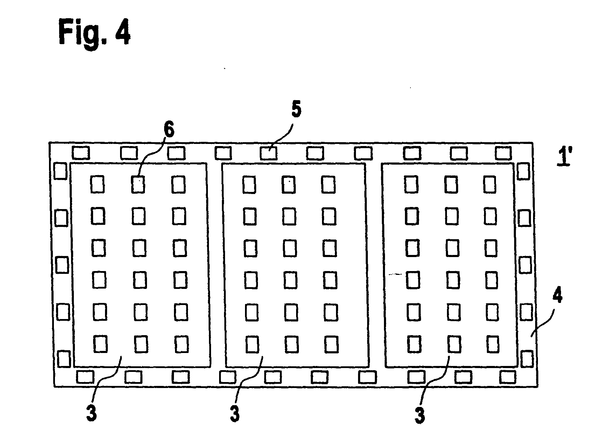

Anstelle der beiden Masken wird eine modifizierte erste Maske verwendet. Ein Bereich 1' der modifizierten ersten Maske ist in Figur 4 dargestellt.

Der erste Bereich 1 weist wiederum Nutzflächen 3 auf, in welchen wiederum die Muster der ersten und zweiten Strukturen 5, 6 erzeugt werden.

Diese Nutzflächen 3 sind identisch zu den Nutzflächen 3 der beiden Masken gemäß den Figuren 1 und 2.

Im Unterschied zu den Masken gemäß den Figuren 1 und 2 wird bei der Maske gemäß Figur 4 in dem Ritzrahmen 4 jeweils eine vorgegebene Anzahl von ersten und zweiten Strukturen 5, 6 erzeugt, wobei die Gesamtzahl dieser Strukturen der Gesamtzahl der Strukturen in dem Ritzrahmen 4 der ersten und zweiten Maske gemäß den Figuren 1 und 2 entspricht.

Im vorliegenden Ausführungsbeispiel werden mit der Maske gemäß Figur 4 im Gebiet der Ritzrahmen 4 vorwiegend erste Strukturen 5 bildende Transistoren mit dünnen Gate-Oxid-Schichten erzeugt, wogegen nur eine geringe Anzahl von zweiten Strukturen 6 erzeugt wird.

## Patentansprüche

1. Verfahren zur Herstellung und Überprüfung wenigstens zweier Strukturen (5, 6) einer elektronischen Schaltung in einem Halbleitersubstrat, umfassend folgende Verfahrensschritte:
Mit einer ersten Maske, bestehend aus einer sich über erste Bereiche (1, 2) des Halbleitersubstrats erstreckenden Anordnung von Nutzflächen (3) und diese umrandenden Ritzrahmen (4), werden nach einem vorgegebenen Muster erste und zweite Strukturen (5, 6) in den Nutzflächen (3) erzeugt und in den Ritzrahmen (4) erste Strukturen (5) erzeugt,
mit einer zweiten Maske, bestehend aus einer sich über zweite Bereiche (2) des Halbleitersubstrats erstreckenden Anordnung von Nutzflächen (3) und diese umrandenden Ritzrahmen (4), werden nach dem vorgegebenen Muster erste und zweite Strukturen (5, 6) in den Nutzflächen (3) erzeugt und in den Ritzrahmen (4) zweite Strukturen (6) erzeugt,
die ersten Strukturen (5) in den Ritzrahmen (4) der ersten Bereiche (1) und die zweiten Strukturen (6) in den Ritzrahmen (4) der zweiten Bereiche (2) werden jeweils zur Überprüfung der ersten und zweiten Strukturen (5, 6) in den Nutzflächen (3) verwendet.

2. Verfahren nach Anspruch 1,
**dadurch gekennzeichnet**,
dass die ersten und zweiten Bereiche (1, 2) alternierend angeordnet sind und sich über die gesamte Oberfläche des Halbleitersubstrats erstrecken.

3. Verfahren nach Anspruch 2,
**dadurch gekennzeichnet,**
**dass** die ersten und zweiten Bereiche (1, 2) schachbrettförmig angeordnet sind.

4. Verfahren nach einem der Ansprüche 1 - 3,
**dadurch gekennzeichnet**,
dass die erste und zweite Maske während einer Technologie-Anlaufphase eingesetzt werden.

5. Verfahren nach Anspruch 4,
**dadurch gekennzeichnet,**
**dass** während der auf die Technologie-Anlaufphase folgenden Produktionsphase die erste und zweite Maske nur zur sporadischen Prüfung ausgewählter Lose von Halbleitersubstraten verwendet werden, und dass ansonsten nur eine modifizierte erste Maske eingesetzt wird, welche eine sich über das Halbleitersubstrat erstreckende Anordnung von Nutzflächen (3) und diese umrandenden Ritzrahmen (4) aufweist, wobei in den Nutzflächen (3) die vorgegebenen Muster von ersten und zweiten Strukturen (5, 6) erzeugt werden, und wobei in den Ritzrahmen (4) jeweils eine vorgegebene Anzahl von ersten und zweiten Strukturen (5, 6) erzeugt wird.

6. Verfahren nach einem der Ansprüche 1 - 5,
**dadurch gekennzeichnet,**
**dass** die beiden Strukturen (5, 6) einer elektronischen Schaltung von zwei unterschiedlichen Gate-Oxid-Dicken von Transistoren gebildet sind.

7. Verfahren nach Anspruch 6,
**dadurch gekennzeichnet**,
dass die erste Maske zur Herstellung von ersten Transistoren mit geringen Gate-Oxid-Dicken verwendet wird, wobei die erste Maske so ausgebildet ist, dass in den Gate-Oxid-Bereichen der ersten Transistoren vor Aufbringen der Gate-Oxid-Schichten eine Stickstoff-Implantation erfolgt, welche das Wachstum der nachfolgend aufgebrachten Gate-Oxid-Schichten hemmt.

8. Verfahren nach einem der Ansprüche 6 oder 7,
**dadurch gekennzeichnet,**
**dass** die zweite Maske zur Herstellung von zweiten Transistoren mit großen Gate-Oxid-Dicken verwendet wird, wobei die zweite Maske so ausgebildet ist, dass in den Gate-Oxid-Bereichen der zweiten Transistoren keine Stickstoff-Implantation vor Aufbringen der Gate-Oxid-Schichten erfolgt.

9. Verfahren nach einem der Ansprüche 6 - 8,
**dadurch gekennzeichnet**,
dass die elektronischen Schaltungen in dem Halbleitersubstrat von DRAM-Strukturen in einem Silizium-Wafer gebildet sind.
